# EUROPEAN PATENT APPLICATION

(11) **EP 4 391 065 A1**
(43) Date of publication of application: **26.06.2024**
(21) Application number: 22216111.9
(22) Date of filing: 22.12.2022
(51) Int. Cl.: H01L 29/04, H01L 21/306, H01L 21/308, H01L 29/06, H01L 29/20, H01L 29/66, H01L 29/78, H01L 21/02

(54) **SHIELDING STRUCTURE FOR A VERTICAL III-NITRIDE SEMICONDUCTOR DEVICE**

(71) Applicant: Imec VZW, 3001 Leuven (BE)
(72) Inventor: LIANG, Hu, 3001 Leuven (BE); GEENS, Karen, 3211 Binkom (BE); DECOUTERE, Stefaan, 3053 Haasrode (BE)
(74) Representative: Winger

(57) **Abstract**

A method for manufacturing an intermediate to a vertical III-nitride semiconductor device comprising a shielding structure (5), the method comprising:
a. obtaining a stack of layers (3) in a reaction chamber of a vapor-phase epitaxy reactor, the stack of layers (3) comprising:
a III-nitride semiconductor stack (1), and
a patterned mask layer (2), the pattern comprising a first region (21) comprising mask material and a second region (22) not comprising mask material and exposing a region (10) of the III-nitride semiconductor stack (1), and

b. controlling the reactor so as to:
b1. selectively desorb material from the region (10) of the III-nitride semiconductor stack (1) exposed by the second region (22) of the patterned mask layer (2) so as to form a trench (4), then
b2. form the shielding structure (5) by epitaxially growing, in the trench, the III-nitride material doped with the p-type dopant.

## Description

### Technical field of the invention

The present invention relates to the field of vertical III-nitride semiconductor devices. In particular, the present invention relates to the field of methods for manufacturing vertical III-nitride semiconductor devices comprising a shielding structure.

### Background of the invention

The active layers of a vertical III-nitride semiconductor device typically comprise a III-nitride semiconductor stack comprising, from top to bottom, an n+ doped III-nitride source layer, a p doped III-nitride body layer, an n- doped III-nitride drift layer, and an n+ doped III-nitride drain layer. A vertical III-nitride metal-oxide-semiconductor field-effect transistors (MOSFET) comprising a trench gate typically extending through the source and body layers with a bottom located in the drift layer may result in a high electric field in the bottom corners of the trench gate when in the blocking state. The high electric field is due to the typical shape of the trench gate. This is particularly true if the MOSFET is used as a power device. This local maximum electric field may lead to an early device failure and may also determine the lifetime of the gate oxide in the blocking state. To solve this problem, a shielding structure, comprising a p+ doped III-nitride filled trench, extending through the source layer and the body layer into the drift layer, wherein a bottom of the trench is located in the drift layer, may be formed around the trench gate, to shield the trench gate from the high electric field.

A typical method for forming the shielding structure comprises forming a patterned mask on the III-nitride semiconductor stack, dry etching of a trench around the location for the trench gate, and subsequent regrowth of p doped III-nitride in the cleaned trench. However, in the state of the art, the interface between the shielding structure and the III-nitride semiconductor stack may become contaminated, thereby reducing the shielding properties of the shielding structure. Furthermore, the trench may be damaged due to the dry etching processes used to form the trench for the shielding structure.

There is thus still a need in the art for devices and methods that address at least some of the above problems.

### Summary of the invention

It is an object of the present invention to provide good methods for manufacturing an intermediate to a vertical III-nitride semiconductor device comprising a shielding structure.

The above objective is accomplished by a method and apparatus according to the present invention.

It is an advantage of embodiments of the present invention that contamination at the interface between the shielding structure and the III-nitride semiconductor stack may be avoided. It is a further advantage of embodiments of the present invention that the damage to the trench for forming the shielding structure, and thus damage at said interface, may be limited. It is, therefore, an advantage of embodiments of the present invention that the shielding structure may effectively shield a trench gate of the vertical III-nitride semiconductor device from high electrical fields that may be present at the bottom corners of the trench gate.

The present invention relates to a method for manufacturing an intermediate to a vertical III-nitride semiconductor device comprising a shielding structure, the method comprising:
a. obtaining a stack of layers in a reaction chamber of a vapor-phase epitaxy reactor, the stack of layers comprising:
   a III-nitride semiconductor stack formed of a III-nitride semiconductor material, the III-nitride semiconductor stack comprising:
      a drain layer doped with an n-type dopant,
      a drift layer over the drain layer, wherein the drift layer is doped with the n-type dopant, wherein a concentration of the n-type dopant in the drift layer is lower than a concentration of the n-type dopant in the drain layer,
      a body layer over the drift layer, wherein the body layer is doped with a p-type dopant, and
      a source layer over the body layer, wherein the source layer is doped with the n-type dopant, and
   a patterned mask layer on the source layer, the pattern comprising a first region comprising mask material and a second region not comprising mask material and exposing a region of the III-nitride semiconductor stack, and
b. controlling the reactor so as to:
   b1. selectively desorb material from the region of the III-nitride semiconductor stack exposed by the second region of the patterned mask layer so as to form a trench extending through the source layer and the body layer into the drift layer, wherein a bottom of the trench is located in the drift layer, then
   b2. form the shielding structure by epitaxially growing, in the trench, the III-nitride material doped with the p-type dopant.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

FIG. 1 and FIG. 2 are schematical representations of vertical cross-sections of a III-nitride semiconductor stack in an exemplary method according to embodiments of the present invention.
FIG. 3A and FIG. 3B are schematical representations of a vertical cross-section and a top view, respectively, of a stack of layers in an exemplary method according to embodiments of the present invention.
FIG. 4A is a plot of the flow, in standard litre per minute (slm), of N₂, H₂, and NH₃ as a function of time, and the temperature of a stack of layers as a function of time, which was used in an experiment for performing the step of desorption of the present invention.
FIG. 4B is a schematical representation of a vertical cross-section of the stack of layers, after selectively desorbing material so as to form a trench, in an exemplary method according to embodiments of the present invention.
FIG. 5 is a schematical representation of a vertical cross-section of the stack of layers, after forming the shielding structure in the trench, in an exemplary method according to embodiments of the present invention.
FIG. 6 is a schematical representation of a vertical cross-section of the stack of layers, after forming a further trench for a gate, in an exemplary method according to embodiments of the present invention.
FIG. 7A and FIG. 7B are schematical representations of a vertical cross-section and horizontal cross-section, respectively, of the stack of layers, after forming a trench gate, in an exemplary method according to embodiments of the present invention.

In the different figures, the same reference signs refer to the same or analogous elements.

### Description of illustrative embodiments

The present invention will be described with respect to particular embodiments and with reference to certain drawings, but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Similarly, it is to be noticed that the term "coupled" should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

Reference will be made to transistors. These are three-terminal devices having a first main electrode such as a drain, a second main electrode such as a source and a control electrode such as a gate for controlling the flow of electrical charges between the first and second main electrodes.

The present invention relates to a method for manufacturing an intermediate to a vertical III-nitride semiconductor device comprising a shielding structure, the method comprising:
a. obtaining a stack of layers in a reaction chamber of a vapor-phase epitaxy reactor, the stack of layers comprising:
   a III-nitride semiconductor stack formed of a III-nitride semiconductor material, the III-nitride semiconductor stack comprising:
      a drain layer doped with an n-type dopant,
      a drift layer over the drain layer, wherein the drift layer is doped with the n-type dopant, wherein a concentration of the n-type dopant in the drift layer is lower than a concentration of the n-type dopant in the drain layer,
      a body layer over the drift layer, wherein the body layer is doped with a p-type dopant, and
      a source layer over the body layer, wherein the source layer is doped with the n-type dopant, and
   a patterned mask layer on the source layer, the pattern comprising a first region comprising mask material and a second region not comprising mask material and exposing a region of the III-nitride semiconductor stack, and
b. controlling the reactor so as to:
   b1. selectively desorb material from the region of the III-nitride semiconductor stack exposed by the second region of the patterned mask layer so as to form a trench extending through the source layer and the body layer into the drift layer, wherein a bottom of the trench is located in the drift layer, then
   b2. form the shielding structure by epitaxially growing, in the trench, the III-nitride material doped with the p-type dopant.

In embodiments, the method further comprises forming a trench gate laterally separated from the shielding structure, comprising, after step b:
c. removing the patterned mask layer, and
either after step c, or comprised in step a, a step of:
   d. providing a further trench, extending through the source layer and the body layer and into the drift layer, wherein a bottom of the further trench is located in the drift layer, and
after steps c and d,
   e. forming the trench gate in the further trench by:
   e1. depositing, on surfaces of the further trench, a dielectric material, then,
   e2. depositing, over the dielectric material, a conductive material, wherein a height within the III-nitride semiconductor stack of a bottom of the conductive material is below a height within the III-nitride semiconductor stack of a top of the drift layer.

In embodiments, step c comprises wet etching of the patterned mask layer. It is an advantage of these embodiments that the wet etching may result in removal of the patterned mask layer without damaging the shielding structure.

In embodiments, the patterned mask layer comprises silicon nitride or silicon oxide. It is an advantage of these embodiments that a selective deposition of the III-nitride material doped with the p-type dopant may be obtained, selective with respect to the patterned mask layer.

In embodiments, a height within the drift layer of a bottom of the further trench is above a height within the drift layer of the bottom of the trench. In embodiments, a ratio of a first distance from a bottom of the drift layer to the height of the bottom of the further trench in the drift layer to a second distance from the bottom of the drift layer to a top of the drift layer is from 0.60 to 0.95. In embodiments, a ratio of a third distance from a bottom of the drift layer to the height of the bottom of the trench in the drift layer to the second distance from the bottom of the drift layer to the top of the drift layer is from 0.50 to 0.90. In embodiments, a ratio of a fourth distance from the height of the bottom of the trench in the drift layer to the height of the bottom of the further trench in the drift layer to the second distance from the bottom of the drift layer to the top of the drift layer is at least 0.05, preferably at least 0.10. It is an advantage of these embodiments that the trench gate may be more efficiently shielded from strong electric fields by the shielding structure.

In embodiments, a lateral distance separating the trench gate and the shielding structure is from 0.5 µm to 50 µm, preferably from 0.5 µm to 10 µm. It is an advantage of these embodiments that a good shielding may be achieved when the trench gate and the shielding structure are close to each other.

In embodiments, the III-nitride semiconductor material is gallium nitride.

In embodiments, the drain layer comprises from 10¹⁷ to 10²⁰ atoms/cm⁻³, preferably from 10¹⁸ to 10¹⁹ atoms/cm⁻³, of the n-type dopant. In embodiments, the drift layer comprises from 5×10¹⁴ to 10¹⁸ atoms/cm⁻³, preferably from 5×10¹⁵ to 10¹⁷ atoms/cm⁻³, of the n-type dopant. In embodiments, the body layer comprises from 10¹⁷ to 10²⁰ atoms/cm⁻³, preferably from 10¹⁸ to 10¹⁹ atoms/cm⁻³, of the p-type dopant. In embodiments, the source layer comprises from 10¹⁷ to 10²⁰ atoms/cm⁻³, preferably from 10¹⁸ to 10¹⁹ atoms/cm⁻³, of the n-type dopant. In embodiments, a concentration of the n-type dopant in the drift layer is at least two times, preferably at least ten times, lower than a concentration of the n-type dopant in the drain layer.

In embodiments, a concentration of the p-type dopant in the shielding structure is from 10¹⁶ to 10²⁰ atoms/cm³, preferably from 10¹⁷ to 10²⁰ atoms/cm³, more preferably from 10¹⁸ to 10²⁰ atoms/cm³. In preferred embodiments, the concentration of the p-type dopant in the shielding structure is higher than a concentration of the p-type dopant in the body layer. It is an advantage of these embodiments that good shielding may be achieved.

In embodiments wherein the III-nitride semiconductor material is gallium nitride, the surfaces of the trench are preferably parallel to planes belonging to a set of planes having Bravais-Miller indices {1-100}. Good epitaxial growth of gallium nitride on surfaces parallel to planes having Bravais-Miller indices {1-100} may be achieved, although epitaxial growth is also possible on surfaces parallel to planes having Bravais-Miller indices {1-101}.

In embodiments, step b1 comprises heating the stack of layers to a temperature of from 700 to 1200 °C, preferably from 900 to 1100 °C. In embodiments, step b1 comprises applying a pressure of from 10 to 200 Torr, preferably from 50 to 100 Torr. In embodiments, in step b1, the atmosphere of the reaction chamber comprises from 30 to 80 vol-% H₂, from 10 to 40 vol-% of an inert gas, e.g., N₂, and from 10 to 30 vol-% of NH₃. It is an advantage of these embodiments that selective desorption from the exposed region may be achieved, selective with respect to the mask material. The desorption may result in surfaces of the trench comprising crystalline III-nitride. Said desorption may be terminated when the trench has reached a preferred depth, e.g., when the bottom of the trench is located in the drift layer. Herein, the desorption may be terminated by cooling the stack of layers to room temperature. Herein, the desorption may be terminated by reducing the concentration of H₂ in the atmosphere of the reaction chamber, e.g., to a concentration below 10 vol-%, preferably below 5 vol-%, more preferably below 1 vol-%. It is an advantage of embodiments of the present invention that, as the desorption is performed in the vapor-phase epitaxy reactor, after the desorption, the epitaxial growth may be performed in the same chamber as where step b1 of desorbing was performed.

In embodiments, the method comprises a step b1' between step b1 and b2 of applying a surface treatment to surfaces of the trench so as to form an epitaxial growth front. In these embodiments, in step b2, the III-nitride material doped with the p-type dopant is epitaxially grown on the epitaxial growth front. It is an advantage of these embodiments that the shielding structure may have good properties, e.g., have a uniform structure. It is an advantage that, as the desorption is performed in the vapor-phase epitaxy reactor, after the desorption, the epitaxial growth front may be formed in the same chamber as where step b1 of desorbing was performed.

In embodiments, in step b2, the trench is completely filled with the III-nitride semiconductor material doped with the p-type dopant.

In embodiments, step b is performed without removing the stack of layers from the reaction chamber. By performing each of the steps in the same reactor, without removing the stack of layers from the reaction chamber, contamination of the shielding structure by any contaminants in the air may be avoided. In particular, the contaminants could deposit on the surfaces of the trench, when the stack of layers would be removed from the reaction chamber between step b1 and b2. This could result in contamination of the interface between the III-nitride semiconductor stack and the shielding structure subsequently formed in the trench.

In embodiments, a cross-section of the shielding structure, in a plane parallel to a top surface of the III-nitride semiconductor stack, forms a loop of the III-nitride material doped with the p-type dopant, said loop surrounding the III-nitride material doped with the n-type dopant. In embodiments, said cross-section may have the form of a circle, a rectangle or a square. In embodiments comprising the trench gate, a cross-section of the shielding structure, in a plane parallel to a top surface of the III-nitride semiconductor stack, forms a loop of the III-nitride material doped with the p-type dopant, surrounding the trench gate. It is an advantage of these embodiments that an efficient shielding of the trench gate by the shielding structure may be achieved. In preferred embodiments comprising the trench gate, the trench gate is formed in the center of the loop.

In embodiments, the vapor-phase epitaxy reactor comprises an outlet fluidically coupled to the reaction chamber, a vacuum pump fluidically coupled to the outlet, and a pressure gauge for detecting a pressure in the reaction chamber. In embodiments, the vapor-phase epitaxy reactor comprises an inlet and a pump for introducing a gas and/or a vapor, through the inlet, into the reaction chamber. In embodiments, the vapor-phase epitaxy reactor comprises a heater for heating the stack of layers.

In embodiments, the vapor-phase epitaxy reactor is selected from a metal-organic chemical vapor deposition reactor and a molecular beam epitaxy reactor. The molecular beam epitaxy reactor may comprise Knudsen cells for evaporating the III material, e.g., Ga, and beaming the evaporated III material to the stack of layers. Preferably, the vapor-phase epitaxy reactor is the metal-organic chemical vapor deposition reactor.

### Example: Manufacturing an intermediate to a vertical III-nitride semiconductor device comprising a shielding structure

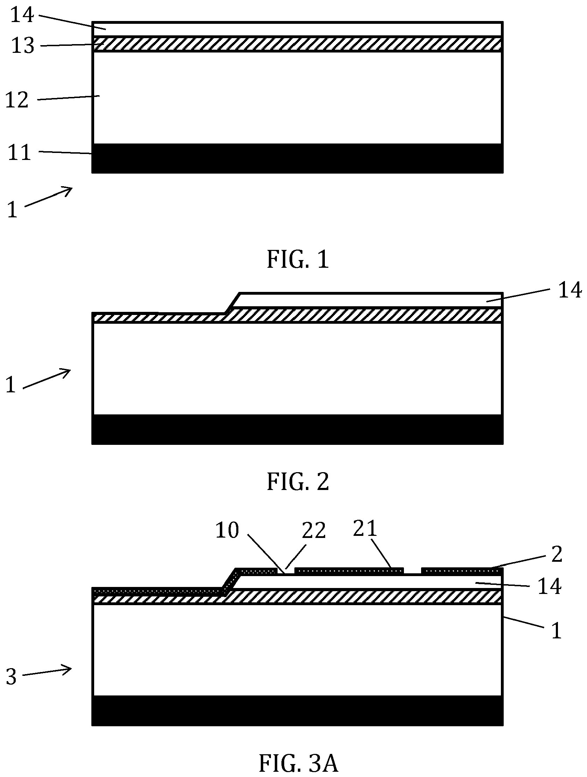

Reference is made to FIG. 1, which is a vertical cross-section of a III-nitride semiconductor stack 1. The III-nitride semiconductor stack 1 is formed of a III-nitride semiconductor material, preferably of gallium nitride. The III-nitride semiconductor stack 1 comprises a drain layer 11 doped with an n-type dopant. The III-nitride semiconductor stack 1 further comprises a drift layer 12 on the drain layer 11. The drift 12 layer is doped with the n-type dopant. A concentration of the n-type dopant in the drift layer 12 is lower than a concentration of the n-type dopant in the drain layer 11. The III-nitride semiconductor stack 1 further comprises a body layer 13 on the drift layer 12, wherein the body layer 13 is doped with a p-type dopant. The III-nitride semiconductor stack 1 further comprises a source layer 14 on the body layer 13, wherein the source layer 14 is doped with the n-type dopant.

Reference is made to FIG. 2. Subsequently, in this example, a so-called mesa etching is performed, wherein a part of the source layer 14 is removed so as to electrically isolate a vertical III-nitride semiconductor device comprising a trench gate to be formed in a region of the III-nitride semiconductor stack 1 where the source layer 14 is not removed.

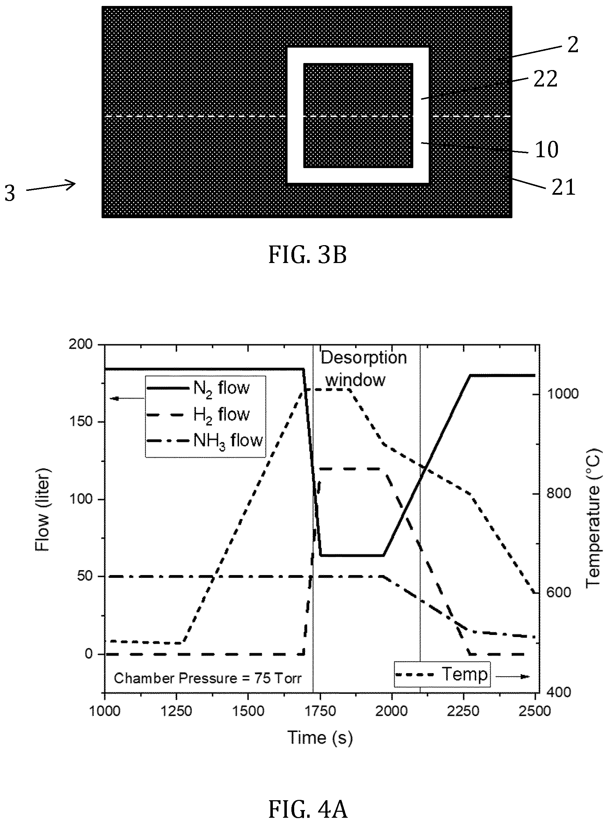

Reference is, simultaneously, made to FIG. 3A, which is a vertical cross-section, and FIG. 3B, which is a top view, of a schematic representation of a stack of layers 3 in accordance with embodiments of the present invention. Herein, FIG. 3A represents a cross-section along the dashed line in FIG. 3B. A patterned mask layer 2 is formed on the III-nitride semiconductor stack 1, on the source layer 14. The pattern of the patterned mask layer 2 comprises a first region 21 comprising mask material and a second region 22 not comprising mask material. The second region 22 exposes a region 10 of the III-nitride semiconductor stack 1, i.e., of the source layer 14 of the III-nitride semiconductor stack 1. In this example, the second region 22 forms a square-shaped loop.

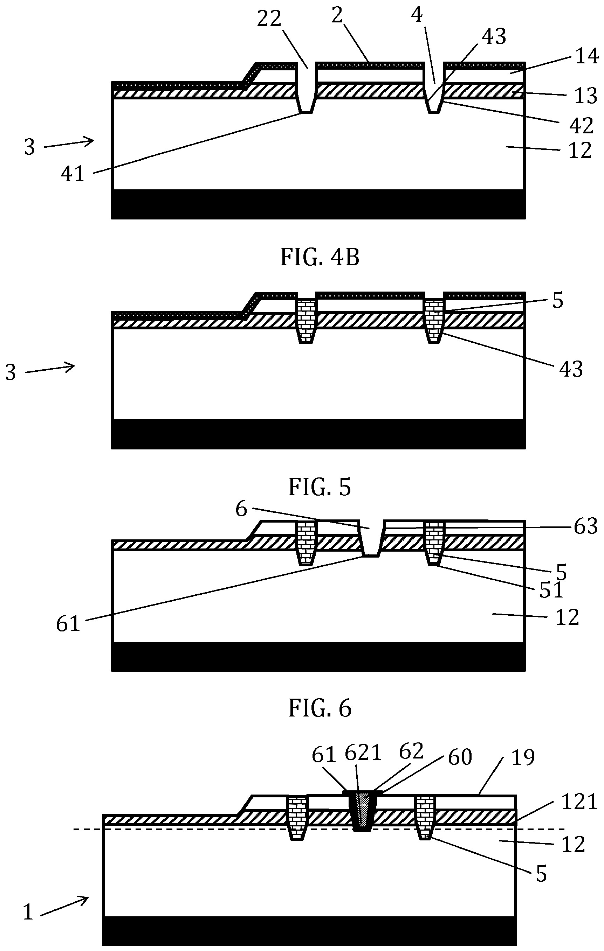

Reference is simultaneously made to FIG. 4A, which is a plot of the flow, in standard litre per minute (slm), of N₂, H₂, and NH₃ as a function of time, and the temperature of the stack of layers 3 as a function of time, which was used in an experiment for performing step b1 of the present invention, and FIG. 4B, that is a vertical cross-section of the stack of layers 3 after said desorption. The stack of layers 3 is introduced in the reaction chamber of a vapor-phase epitaxy reactor. In an experiment to achieve desorption, a stack of layers 3 similar as in this example was heated from room temperature to 1010 °C, wherein an atmosphere of the reaction chamber contained N₂ and NH₃, for which volumetric flow rates into the reaction chamber of 190 standard litre per minute (slm) and 50 slm, respectively, were used. The pressure in the reaction chamber was 75 torr. Subsequently, the atmosphere of the reaction chamber was changed within 60 seconds, so that it contained H₂, N₂ and NH₃, for which volumetric flow rates into the reaction chamber of 120 slm, 64 slm, and 50 slm, respectively, were used. H₂ may result in the desorption by selectively reacting with the III-nitride semiconductor material. The temperature of the stack of layers 3 was kept at 1010 °C so that III-nitride semiconductor material is selectively desorbed from the region 10 of the III-nitride semiconductor stack 1 that is exposed by the second region 22 of the patterned mask layer 2. The temperature of the stack of layers 3 was retained at 1010 °C until a trench 4 is formed having a preferred depth. When the preferred depth was reached, the temperature in of the stack of layers 3 was ramped down, i.e., reduced, to room temperature, thereby terminating the desorption. At the same time, the volumetric flow rate of H₂ was reduced to zero. FIG. 4A indicates the range for the volumetric flow rates for H₂, N₂ and NH₃ and temperature, in combination, for which the desorption was achieved. The above experiment was performed in a Veeco Maxbright reactor, for which the stack of layers 3 was retained at 1010 °C for 160 seconds, wherein trenches were obtained having a depth of 1.5µm. Although the above values resulted in good desorption in the Veeco Maxbright reactor that was used, the skilled person will realize that a different temperature, e.g., within the range 700-1200°C, and pressure, e.g., within the range 10-200 Torr, and different volumetric flow rates for H₂, N₂ and NH₃, e.g., within the ranges 30 to 80 vol-% H₂, from 10 to 40 vol-% of an inert gas, and from 10 to 30 vol-% of NH₃, may need to be applied when a different vapor-phase epitaxy reactor is used.

Thus, for example using the above parameters in the vapor-phase epitaxy reactor, III-nitride semiconductor material is selectively desorbed from the region 10 of the III-nitride semiconductor stack 1 that is exposed by the second region 22 of the patterned mask layer 2. Said desorption is performed so as to form a trench 4 extending through the source layer 14 and the body layer 13 into the drift layer 12. Herein, a bottom 41 of the trench 4 is located in the drift layer 12. Preferably, in particular when the III-nitride semiconductor material is GaN, the trench 4 comprises at least one surface 42, e.g., surfaces, which is parallel to a plane belonging to a set of planes having Bravais-Miller indices {1-100}, on which good epitaxial growth of III-nitride semiconductor material, e.g., GaN, may be obtained.

After formation of the trench 4, in this example, an optional surface treatment may be performed on surfaces 43, e.g., all surfaces, of the trench 4. The surface treatment may be performed after the formation of the trench, without removing the stack of layers 3 from the reaction chamber. Thereby, an epitaxial growth front may be formed, for example, by saturating all dangling bonds on the surfaces 43 of the trench 4. The dangling bonds may be a result of the desorption process, and may inhibit an epitaxial growth from the surfaces 43 of the trench 4.

Reference is made to FIG. 5. After said surface treatment, III-nitride material doped with the p-type dopant, may be epitaxially grown on the epitaxial growth front formed by the surfaces 43 of the trench. The epitaxial growth is typically performed after the surface treatment, without removing the stack of layers 3 from the reaction chamber. The III-nitride material doped with the p-type dopant in the trench forms a shielding structure 5 in the trench. In this example, the III-nitride material doped with the p-type dopant completely fills the trench.

Reference is made to FIG. 6. After forming the shielding structure 5, the patterned mask layer 2 is removed from the top of the III-nitride semiconductor stack 1. Subsequently, a further trench 6 is formed in the center of the loop formed by the shielding structure 5. Herein, the further trench 6 extends into the drift layer 12. In this example, a height within the drift layer 12 of a bottom 61 of the further trench 6 is above a height within the drift layer 12 of the bottom of the trench, i.e., of the bottom 51 of the shielding structure 5.

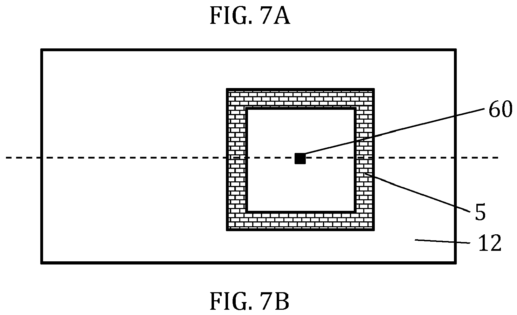

Reference is, simultaneously, made to FIG. 7A, which is a vertical cross-section, and FIG. 7B, which is a horizontal cross-section, of a schematic representation of the III-nitride semiconductor stack after formation of the shielding structure 5 and the trench gate 60 in accordance with embodiments of the present invention. Herein, the dashed line in FIG. 7A is the same line as the dashed line in FIG. 7B. On surfaces 63 of the further trench 6 (cfr. FIG. 6), first, a dielectric material 61 may be deposited, and subsequently, a conductive material 62 on the dielectric material 61. Herein, a height within the III-nitride semiconductor stack 1 of a bottom 621 of the conductive material 62 is below a height within the III-nitride semiconductor stack 1 of a top 121 of the drift layer 12. As may be observed in FIG. 7B, a cross-section of the shielding structure 5, in a plane parallel to a top surface 19 of the III-nitride semiconductor stack 1, forms a loop of the III-nitride material doped with the p-type dopant, of which the shielding structure 5 is formed, said loop surrounding the III-nitride material doped with the n-type dopant of which the drift layer 12 is formed.

It is to be understood that although preferred embodiments, specific constructions and configurations, as well as materials, have been discussed herein for devices according to the present invention, various changes or modifications in form and detail may be made without departing from the scope of this invention. Steps may be added or deleted to methods described within the scope of the present invention.

## Claims

1. A method for manufacturing an intermediate to a vertical III-nitride semiconductor device comprising a shielding structure (5), the method comprising:
a. obtaining a stack of layers (3) in a reaction chamber of a vapor-phase epitaxy reactor, the stack of layers (3) comprising:
a III-nitride semiconductor stack (1) formed of a III-nitride semiconductor material, the III-nitride semiconductor stack (1) comprising:
a drain layer (11) doped with an n-type dopant,
a drift layer (12) over the drain layer (11), wherein the drift layer (12) is doped with the n-type dopant, wherein a concentration of the n-type dopant in the drift layer (12) is lower than a concentration of the n-type dopant in the drain layer (11),
a body layer (13) over the drift layer (12), wherein the body layer (13) is doped with a p-type dopant, and
a source layer (14) over the body layer (13), wherein the source layer (14) is doped with the n-type dopant, and
a patterned mask layer (2) on the source layer (14), the pattern comprising a first region (21) comprising mask material and a second region (22) not comprising mask material and exposing a region (10) of the III-nitride semiconductor stack (1), and
b. controlling the reactor so as to:
b1. selectively desorb material from the region (10) of the III-nitride semiconductor stack (1) exposed by the second region (22) of the patterned mask layer (2) so as to form a trench (4) extending through the source layer (14) and the body layer (13) into the drift layer (12), wherein a bottom (41) of the trench (4) is located in the drift layer (12), then
b2. form the shielding structure (5) by epitaxially growing, in the trench, the III-nitride material doped with the p-type dopant.

2. The method according to claim 1, further comprising forming a trench gate (60) laterally separated from the shielding structure (5), comprising, after step b:
c. removing the patterned mask layer (2), and
either after step c, or comprised in step a, a step of:
d. providing a further trench (6), extending through the source layer (14) and the body layer (13) and into the drift layer (12), wherein a bottom (61) of the further trench (6) is located in the drift layer (12), and
after steps c and d,
e. forming the trench gate (60) in the further trench (6) by:
e1. depositing, on surfaces (63) of the further trench (6), a dielectric material (61), then,
e2. depositing, over the dielectric material (61), a conductive material (62), wherein a height within the III-nitride semiconductor stack (1) of a bottom (621) of the conductive material (62) is below a height within the III-nitride semiconductor stack (1) of a top (121) of the drift layer (12).

3. The method according to claim 2, wherein a height within the drift layer (12) of a bottom (61) of the further trench (6) is above a height within the drift layer (12) of the bottom of the trench (41).

4. The method according to claim 2 or 3, wherein a lateral distance separating the trench gate (60) and the shielding structure (5) is from 0.5 µm to 10 µm.

5. The method according to any of the previous claims, wherein a concentration of the p-type dopant in the shielding structure (5) is from 10¹⁶ to 10²⁰ atoms/cm³.

6. The method according to any of the previous claims, wherein the III-nitride semiconductor material is gallium nitride.

7. The method according to claim 6, wherein the surfaces (43) of the trench (4) are parallel to planes belonging to a set of planes having Bravais-Miller indices {1-100]}.

8. The method according to any of the previous claims, wherein, in step b2, the trench (4) is completely filled with the III-nitride semiconductor material doped with the p-type dopant.

9. The method according to any of the previous claims, wherein step b is performed without removing the stack of layers (1) from the reaction chamber.

10. The method according to any of the previous claims, wherein a cross-section of the shielding structure (5), in a plane parallel to a top surface (19( of the III-nitride semiconductor stack (1), forms a loop of the III-nitride material doped with the p-type dopant, said loop surrounding the III-nitride material doped with the n-type dopant.

11. The method according to claim 10 as dependent on claim 2, wherein the trench gate (60) is formed in the center of the loop.

12. The method according to any of the previous claims, wherein the patterned mask layer (2) comprises silicon nitride or silicon oxide.

13. The method according to any of the previous claims, wherein step b1 comprises heating the stack of layers to a temperature of from 700 to 1200 °C.

14. The method according to any of the previous claims, wherein, in step b1, the atmosphere in the reaction chamber comprises from 30 to 80 vol-% H₂, from 10 to 40 vol-% of an inert gas, and from 10 to 30 vol-% of NH₃.

15. The method according to any of the previous claims, wherein step b1 comprises applying a pressure of from 10 to 200 Torr.
